(19) Europäisches Patentamt
European Patent Office
Office européen des brevets

(11) EP 4 660 267 A1

(12) # EUROPEAN PATENT APPLICATION
published in accordance with Art. 153(4) EPC

(43) Date of publication:
**10.12.2025 Bulletin 2025/50**

(21) Application number: **24750012.7**

(22) Date of filing: **22.01.2024**

(51) International Patent Classification (IPC):
***C09J 4/02*** *(2006.01)* ***C08F 20/10*** *(2006.01)*
***C08F 220/20*** *(2006.01)* ***C08F 290/12*** *(2006.01)*
***C09J 11/06*** *(2006.01)* ***C09J 133/00*** *(2006.01)*
***H01L 21/02*** *(2006.01)*

(52) Cooperative Patent Classification (CPC):
**C08F 20/10; C08F 220/20; C08F 290/12; C09J 4/00; C09J 11/06; C09J 133/00; H01L 21/02**

(86) International application number:
**PCT/JP2024/001600**

(87) International publication number:
**WO 2024/162059 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.01.2023 JP 2023013514**

(71) Applicant: **Denka Company Limited**
**Tokyo 103-8338 (JP)**

(72) Inventors:
- **YAMAMOTO, Shota**
  **Tokyo 103-8338 (JP)**
- **TANIGAWA HOSHINO, Takako**
  **Tokyo 103-8338 (JP)**
- **TAKAHASHI, Yusuke**
  **Tokyo 103-8338 (JP)**
- **KURIMURA, Hiroyuki**
  **Tokyo 103-8338 (JP)**

(74) Representative: **Hoffmann Eitle**
**Patent- und Rechtsanwälte PartmbB**
**Arabellastraße 30**
**81925 München (DE)**

(54) **TEMPORARY FIXING COMPOSITION SUPPRESSING REMAINING OF BUBBLES**

(57) A composition for temporary bonding which is photocurable, contains: (A) a (meth)acrylate monomer; and (B) a photo radical polymerization initiator, in which a viscosity of the composition for temporary bonding at 23°C determined in accordance with JIS Z 8803:2011 is 500 mPa·s or more at a shear rate of 1 $sec^{-1}$, and a specific gravity of the composition for temporary bonding at 23°C determined in accordance with JIS Z 8804:2012 is 1.000 $g/cm^3$ or more and 1.050 $g/cm^3$ or less.

EP 4 660 267 A1

## Description

### Technical Field

The present invention relates to a composition that can suppress bubble retention when used for temporary bonding.

### Background Art

In manufacturing electronic devices, inorganic materials as represented by silicon are used as a substrate. A wafer-type substrate having a thickness of about several hundred μm, which is obtained by subjecting a surface thereof to a process such as forming an insulating film, forming a circuit, or thinning by grinding, is often used. However, since many of the substrates are made of a material that is brittle and easily cracked, a breakage prevention measure is required particularly in thinning by grinding. As this measure, conventionally, a method of sticking a protective tape for temporary bonding, which can be peeled off after completion of a processing step, to a surface (also referred to as a back surface) opposite to a grinding target surface is adopted. This tape uses an organic resin film as a base material, has flexibility, but has insufficient strength and heat resistance, and is not suitable for use in a step at a high temperature.

Therefore, a system has been proposed in which a substrate for an electronic device is bonded to a support such as silicon or glass via an adhesive to impart sufficient durability to withstand conditions of a step of grinding a back surface or forming a back surface electrode. What is important in this case is an adhesive layer for bonding the substrate to the support. This requires that the substrate can be bonded to the support without gaps, sufficient durability to withstand subsequent steps is required, and also this requires that a finally thinned wafer can be easily peeled off from the support, that is, temporarily bonded.

In the processing of such a wafer, a spin coating step, a vacuum bonding and photocuring step, a thinning processing step by grinding or polishing, a high temperature treatment step, a laser peeling step, and a temporary bonding agent removal step are mainly performed.

In the spin coating step, in order to make it possible to uniformly form a film of the temporary bonding agent on the wafer, it is required that the temporary bonding agent has a suitable viscosity and is a Newtonian fluid (or has a shear viscosity that is independent of a shear rate).

In the vacuum bonding/UV curing step, the temporary bonding agent is required to be capable of being cured in a short time upon light irradiation with ultraviolet (UV) rays or the like on a support such as glass, and to generate little outgas (low outgassing property).

In the thinning processing step by grinding or polishing, in order to avoid damage due to local application of a load of a grinding machine to the substrate, the temporary bonding agent is required to have appropriate hardness capable of preventing local sinking of the substrate while distributing the load in the in-plane direction and maintaining flatness. Furthermore, adhesion to the support, an appropriately high elastic modulus to protect an edge, and chemical resistance are also required.

In the high temperature treatment step, the temporary bonding agent is required to have heat resistance capable of withstanding high-temperature treatment in vacuum for a long time (for example, at 300°C or higher for one hour or more).

In the laser peeling step, the temporary bonding agent is required to be peeled off quickly by a laser such as a UV laser.

In the removal step, in addition to easy peelability that allows the substrate to be easily peeled from the support, cohesion characteristics and easy cleanability for not leaving residues of an adhesive on the substrate after peeling are required.

In view of such a background, for example, Patent Literature 1 discloses a composition for temporary bonding containing (A-1) a monofunctional (meth)acrylate in which a side chain is an alkyl group having 18 or more carbon atoms and Tg of a homopolymer is -100°C to 60°C, (A-2) a polyfunctional (meth)acrylate, (B) a polyisobutene homopolymer and/or a polyisobutene copolymer, and (C) a photo radical polymerization initiator, and claims that it is excellent in heat resistance, a low outgassing property, and peelability.

In addition, Patent Literature 2 discloses a manufacturing method in which a composition containing carbon black as a light absorber is used for temporary bonding, and a photothermal conversion layer is separated into two by a gas generated by thermal decomposition to separate a support and a semiconductor chip.

### Citation List

Patent Literature

Patent Literature 1: WO 2021/235406 A
Patent Literature 2: JP 2005-159155 A

Summary of Invention

Technical Problem

In the spin coating step described above, a liquid composition for temporary bonding is dropped onto a substrate, and the substrate is rotated at a predetermined rotation speed to apply the composition to a surface of the substrate. However, if the temporary bonding agent does not remain on the substrate to some extent against this rotation, a phenomenon called "backflow" occurs in which the temporary bonding agent drips down and wraps around the back of the substrate. Since the occurrence of the backflow causes contamination of a manufacturing apparatus, it is important to suppress the backflow. For this reason, attempts have been made to increase the viscosity of the temporary bonding agent.

On the other hand, in this case, when the viscosity of the temporary bonding agent is increased, a problem occurs in which bubbles generated in the temporary bonding agent cannot be removed in the vacuum bonding step subsequent to the spin coating step. If the bubbles remain, there is a concern that a product quality may be adversely affected.

In the prior art, such contradictory problems cannot be solved together, and a solution thereto is desired.

In addition, in the temporary bonding method as in Patent Literature 2, the amount of heat generated from a filler such as carbon black is large, and therefore the adverse effects on an object to be manufactured cannot be ignored, and furthermore, the problem of contamination caused by the filler cannot be solved.

The present invention has been made in view of the above problems, and an object thereof is to provide a composition for temporary bonding that obtains an effect that both suppressing backflow and promoting bubble removal in temporary bonding applications can be achieved.

Solution to Problem

In order to solve the above-described problems, the present inventors have conceived to control both the viscosity and the specific gravity, and completed the present invention. That is, the present invention can provide the following aspects.

Aspect 1.

A composition for temporary bonding which is photocurable, containing:

(A) a (meth)acrylate monomer; and
(B) a photo radical polymerization initiator,

wherein a viscosity of the composition for temporary bonding at 23°C determined in accordance with JIS Z 8803:2011 is 500 mPa·s or more at a shear rate of 1 $sec^{-1}$, and
a specific gravity of the composition for temporary bonding at 23°C determined in accordance with JIS Z 8804:2012 is 1.000 $g/cm^3$ or more and 1.050 $g/cm^3$ or less.

Aspect 2.

The composition for temporary bonding according to aspect 1,

wherein the component (A) contains
(A-1) a polyfunctional (meth)acrylate monomer, and
(A-2) a monofunctional (meth)acrylate monomer.

Aspect 3.

The composition for temporary bonding according to aspect 2, wherein a mass ratio of the component (A-1) to the

component (A-2) is in a range of (A-1):(A-2) = 2:1 to 1:2.

Aspect 4.

The composition for temporary bonding according to aspect 2 or 3, wherein the component (A-2) contains an aliphatic monofunctional (meth)acrylate monomer having 15 or more and 32 or less carbon atoms.

Aspect 5.

The composition for temporary bonding according to any one of aspects 1 to 4, further containing:
(C) a (meth)acrylate polymer.

Aspect 6.

The composition for temporary bonding according to any one of aspects 1 to 5, which does not contain a methacrylate monomer and a methacrylate polymer.

Aspect 7.

The composition for temporary bonding according to any one of claims 1 to 6, further containing:
(D) a UV absorber.

Aspect 8.

The composition for temporary bonding according to any one of aspects 1 to 7, which does not contain a filler.

Aspect 9.

A method for manufacturing a semiconductor device, the method including the steps of:

applying a composition to a semiconductor wafer substrate and/or a support member;
bonding the semiconductor wafer substrate and the support member in a vacuum environment with the composition interposed therebetween; and
temporarily bonding the semiconductor wafer substrate and the support member to each other by irradiating the semiconductor wafer substrate and the support member bonded to each other with light and curing the composition,
wherein the composition before curing contains:

(A) a (meth)acrylate monomer; and
(B) a photo radical polymerization initiator,

a viscosity of the composition at 23°C determined in accordance with JIS Z 8803:2011 is 500 mPa·s or more at a shear rate of 1 $sec^{-1}$, and
a specific gravity of the composition at 23°C determined in accordance with JIS Z 8804:2012 is 1.000 $g/cm^3$ or more and 1.050 $g/cm^3$ or less.

Aspect 10.

The method according to aspect 9, wherein the composition is applied to the semiconductor wafer substrate and/or the support member by spin coating.

Aspect 11.

The method according to aspect 9 or 10, wherein an application thickness of the composition on the semiconductor wafer substrate and/or the support member is in a range of 50 μm or more and 70 μm or less.

Aspect 12.

The method according to any one of aspects 9 to 11, wherein the vacuum environment is within a range of a

vacuum degree of 20 Pa or less.

Aspect 13.

A composition for temporary bonding containing:

(A) a (meth)acrylate monomer; and
(B) a polymerization initiator,

wherein a viscosity of the composition at 23°C determined in accordance with JIS Z 8803:2011 is 500 mPa·s or more at a shear rate of 1 $sec^{-1}$, and
a specific gravity of the composition at 23°C determined in accordance with JIS Z 8804:2012 is 1.000 $g/cm^3$ or more and 1.050 $g/cm^3$ or less.

Advantageous Effects of Invention

According to the present invention, it is possible to obtain an effect that both suppressing backflow and promoting bubble removal in temporary bonding applications can be achieved.

Description of Embodiments

In the present specification, unless otherwise specified, a numerical range includes an upper limit and a lower limit thereof. In the present specification, a monofunctional (meth)acrylate refers to a compound having one (meth)acryloyl group in one molecule. A polyfunctional (meth)acrylate refers to a compound having two or more (meth)acryloyl groups in one molecule. An n-functional (meth)acrylate refers to a compound having n (meth)acryloyl groups in one molecule. A polymerizable functional group in the polyfunctional (meth)acrylate may have only an acryloyl group, may have only a methacryloyl group, or may have both an acryloyl group and a methacryloyl group.

In an embodiment of the present invention, it is possible to provide a photocurable composition containing (A) a (meth)acrylate monomer and (B) a photo radical polymerization initiator, and having a viscosity and specific gravity that satisfy predetermined conditions. Hereinafter, in the present specification, the photocurable composition may be simply referred to as a "composition" or a "temporary bonding agent". In addition, in another embodiment, a cured product obtained by curing the composition can also be provided, and the curing can be performed with light (for example, ultraviolet light) having a wavelength corresponding to the component (B).

The viscosity of the present composition which is curable (that is, in a liquid state before curing, a viscous state, a varnish-like state, or the like) is a value determined at a temperature of 23°C and a shear rate of 1 $sec^{-1}$ by a measurement method in accordance with JIS Z 8803:2011, and is required to be 500 mPa·s or more. When the viscosity is within this range, an effect of easily suppressing the backflow on a substrate in a spin coating step and an effect of improving workability are obtained. The viscosity may be preferably in a range of 500 mPa.s or more and 10,000 mPa.s or less, more preferably in a range of 1000 mPa.s or more and 10000 mPa.s or less, still more preferably in a range of 1000 mPa.s or more and 5000 mPa.s or less, and further preferably in a range of 1000 mPa.s or more and 4000 mPa.s or less.

The viscosity in the present specification can be measured by, for example, an E-type viscometer (for example, rotation speed: 10 rpm), and a cone plate can be used as a measurement jig in this case.

The specific gravity of the present composition before curing is a value determined at a temperature of 23°C by a measurement method in accordance with JIS Z 8804:2012, and is required to be 1.000 $g/cm^3$ or more and 1.050 $g/cm^3$ or less. When the specific gravity is within this range, an effect that bubbles are easily removed is obtained. The specific gravity may be preferably 1.005 $g/cm^3$ or more and 1.050 $g/cm^3$ or less, and more preferably 1.010 $g/cm^3$ or more and 1.050 $g/cm^3$ or less.

The specific gravity (liquid specific gravity) in the present specification can be measured, for example, using a pycnometer (for example, a 5 mL pycnometer) based on the following formula.

$$\text{Specific gravity} = (C-A)/(B-A)$$

In the formula, A represents mass of a pycnometer, B represents mass of pure water, and C represents mass of a sample.

In the prior art, since viscosity and specific gravity is in a trade-off relationship, it has been considered that it is difficult to conveniently control both parameters. The present inventors have developed a method capable of controlling both the viscosity and the specific gravity contrary to the conventional common sense, and conceived the present invention.

A content of the component (A) is preferably 60 to 100 mass%, 70 to 98 mass%, 80 to 96 mass%, or 85 to 94 mass% with respect to a total amount of a composition for temporary bonding.

Any (meth)acrylate monomer as the component (A) contained in the present composition can be selected as long as a predetermined viscosity and specific gravity can be obtained. In a preferred embodiment, the component (A) can contain one or both of (A-1) a polyfunctional (meth)acrylate monomer and (A-2) a monofunctional (meth)acrylate monomer. In a case where both the components are contained, a mass ratio of the component (A-1) to the component (A-2) may be, for example, in a range of (A-1):(A-2) = 2:1 to 1:2, and more preferably in a range of 2:1 to 1:1. When the amount of the component (A-1) is equal to that of the component (A-2) or larger than that of the component (A-2), an effect of easily controlling viscosity and specific gravity is obtained.

The component (A-1) may contain any bifunctional or higher functional (meth)acrylate monomer. Examples of a bifunctional (meth)acrylate monomer may include aromatic bifunctional (meth)acrylate and/or aliphatic bifunctional (meth)acrylate.

The aromatic bifunctional (meth)acrylate can be added to the present composition to constitute a rigid skeleton. When the aromatic bifunctional (meth)acrylate has a condensed ring skeleton, the rigidity is further enhanced. Examples of the aromatic bifunctional (meth)acrylate include 9,9-bis[4-(2-hydroxy $C_1$ to $C_{20}$ alkoxy)phenyl]fluorene di(meth) acrylate, $C_1$ to $C_{20}$ alkoxylated bisphenol A di(meth)acrylate, benzyl di(meth)acrylate, 1,3-bis(2-(meth)acryloyloxy $C_1$ to $C_{20}$ alkyl)benzene, 2,2-bis(4-(meth)acryloxydiethoxyphenyl)propane, 2,2-bis(4-(meth)acryloxypropoxyphenyl)propane, and 2,2-bis(4-(meth)acryloxytetraethoxyphenyl)propane, and structural isomers thereof. Preferably, a di(meth) acrylate having a condensed ring skeleton, for example, a skeleton of fluorene, indene, indecene, anthracene, azulene, or triphenylene may be contained.

Examples of the aliphatic bifunctional (meth)acrylate include $C_1$ to $C_{20}$ alkyldiol di(meth)acrylate. Examples of the $C_1$ to $C_{20}$ alkyldiol di(meth)acrylate may include 1,3-butanediol di(meth)acrylate, 1,4-butanediol di(meth)acrylate, 1,6-hexanediol di(meth)acrylate, 1,9-nonanediol di(meth)acrylate, 1,10-decanediol di(meth)acrylate, neopentyl glycol di(meth)acrylate, neopentyl glycol-modified trimethylolpropane di(meth)acrylate, stearic acid-modified pentaerythritol di(meth)acrylate, tripropylene glycol di(meth)acrylate, isocyanuric acid ethylene oxide-modified di(meth)acrylate, and caprolactone-modified hydroxypivalic acid neopentyl glycol di(meth)acrylate.

Examples of the aliphatic bifunctional (meth)acrylate further include $C_1$ to $C_{20}$ alkoxylated hydrogenated bisphenol A di(meth)acrylate, 1,3-di(meth)acryloyloxyadamantane, tricyclo $C_{10}$ to $C_{20}$ alkanedimethanol di(meth)acrylate (for example, tricyclo decanedimethanol di(meth)acrylate), and dicyclo $C_5$ to $C_{20}$ di(meth)acrylate, and structural isomers thereof.

Examples of the trifunctional (meth)acrylate include isocyanuric acid ethylene oxide-modified tri(meth)acrylate, pentaerythritol tri(meth)acrylate, trimethylolpropane tri(meth)acrylate, and tris[(meth)acryloyloxyethyl]isocyanurate.

Examples of the tetrafunctional or higher functional (meth)acrylate include ditrimethylolpropane tetra(meth) acrylate, dimethylolpropane tetra(meth)acrylate, pentaerythritol tetra(meth)acrylate, pentaerythritol ethoxy tetra(meth) acrylate, dipentaerythritol penta(meth)acrylate, and dipentaerythritol hexa(meth)acrylate.

The (A-2) component may contain any monofunctional (meth)acrylate monomer. The monofunctional (meth) acrylate monomer is preferably a monofunctional (meth)acrylate having a molecular weight of 550 or less, and more preferably a monofunctional alkyl (meth)acrylate having an alkyl group.

The component (A-2) preferably has the following structural formula.

[Chem. 1]

Formula 1

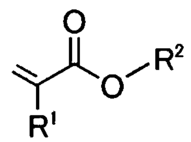

In the formula, $R^1$ is a hydrogen atom or a methyl group, and more preferably a hydrogen atom. That is, acrylate is more preferable than methacrylate from the viewpoint of improving heat resistance and the viewpoint of improving cleanability. This is an effect that arises due to the fact that methacrylate generally has a lower reactivity and thus the amount of residual monomer tends to increase. In an embodiment, it is preferable that the component (A-2) do not contain a methacrylate monomer, it is more preferable that the entire component (A) do not contain a methacrylate monomer, and it is still more preferable that the entire composition do not contain a methacrylate (containing a monomer or a polymer).

In the formula, $R^2$ is an alkyl group, and the number of carbon atoms thereof is preferably 15 to 32 and more preferably 15 to 21 from the viewpoint of making defects due to deposition less likely to occur during production. Examples

of the monofunctional alkyl (meth)acrylate in which $R^2$ is an alkyl group having 15 to 32 carbon atoms preferably include aliphatic (meth)acrylates having a linear, branched, or alicyclic alkyl group, such as stearyl (meth)acrylate, isostearyl (meth)acrylate, nonadecyl (meth)acrylate, eicodecyl (meth)acrylate, behenyl (meth)acrylate, 2-decyl-1-tetradecanyl (meth)acrylate, or 2-tetradecyl-1-octadecanyl (meth)acrylate. From the viewpoint of making crystallization less likely to occur, $R^2$ is more preferably a branched alkyl group. By using such a component (A-2) having long chain, high molecular weight, low polarity, and strong characteristics of an aliphatic hydrocarbon, not only the balance between the viscosity and the specific gravity can be easily adjusted, but also the effect that the low volatility, chemical resistance, and heat resistance of the composition can be improved is obtained.

The alkyl group is preferably one or more selected from a linear alkyl group, a branched alkyl group, and an alicyclic alkyl group, and more preferably one or more selected from a linear alkyl group and a branched alkyl group. From the viewpoint of improving compatibility with the component (A-1), the component (A-2) preferably has a long-chain and branched or cyclic alkyl group, and for example, preferably has a branched alkyl group such as an isostearyl group, an isotetracosanyl group (such as a 2-decyl-1-tetradecanyl group), and an isotriacontanyl group (such as a 2-tetradecyl-1-octadecanyl group) having, for example, 18 to 40 carbon atoms and more preferably 18 to 32 carbon atoms, or a cycloalkyl group.

Other examples of the component (A-2) include an aromatic monofunctional (meth)acrylate, and may include, for example, $C_1$ to $C_{20}$ alkylphenol (meth)acrylate and $C_1$ to $C_{20}$ alkylphenol EO (ethylene oxide)-modified (meth)acrylate.

Although it is not desired to be bound by a specific hypothesis, in general, an aliphatic monofunctional (meth) acrylate has low heat resistance, and therefore is considered to be a component that is rather disadvantageous in the temporary bonding agent according to the prior art, and cannot be said to be a component that has been actively used. However, the present inventors have focused on the low polarity of the aliphatic monofunctional (meth)acrylate, and have conceived that there is an effect of reducing the viscosity and specific gravity. This effect is particularly remarkable in an aliphatic monofunctional acrylate having an alkyl group having 15 to 32 (preferably 15 to 21) carbon atoms.

As a more preferred embodiment, a composition containing a combination of an aromatic bifunctional or trifunctional acrylate as the (A-1) component and an aliphatic monofunctional $C_{15}$ to $C_{32}$ alkyl acrylate as the (A-2) component can be provided. When the combination is included, an effect that the balance between the specific gravity and the viscosity is easily adjusted is obtained.

From the viewpoint of appropriately adjusting the specific gravity, it is preferable that the present composition does not contain a fluorine monomer. Although a fluorine monomer has been considered preferable in some cases from the viewpoint of improving heat resistance in the prior art, but it is considered to be rather unpreferable in the present invention. A composition according to another embodiment may contain a fluorine monomer as long as the specific gravity and the viscosity can be adjusted.

The present composition does not need to separately provide an adhesive layer and a photothermal conversion layer as in Patent Literature 2, and can function only by forming one layer. Therefore, it is preferable that the present composition does not contain a filler such as carbon black.

The polymerization initiator as the component (B) contained in the present composition, preferably the photo radical polymerization initiator is a substance capable of initiating radical polymerization of the component (A) (and other monomers contained as necessary) upon irradiation with light, and refers to a compound in which a molecule is cleaved by irradiation with, for example, ultraviolet rays or visible light (for example, at a wavelength of 350 to 700 nm, preferably 365 to 500 nm, and more preferably 385 to 450 nm) and split into two or more radicals. Examples of the photo radical polymerization initiator include bis(2,4,6-trimethylbenzoyl)phenylphosphine oxide, 2,4,6-trimethylbenzoyldiphenylphosphine oxide, bis($\eta^5$-2,4-cyclopentadiene-1-yl)-bis(2,6-difluoro-3-(1H-pyrrole-1-yl)-phenyl) titanium, 2-benzyl-2-dimethylamino-1-(4-morpholinophenyl)-butane-1-one, 2-dimethylamino-2-(4-methylbenzyl)-1-(4-morpholine-4-ylphenyl)-butane-1-one, 1-[4-(phenylthio)phenyl]-1,2-octanedione 2-O-benzoyloxime, and 1-[9-ethyl-6-(2-methylbenzoyl)-9H-carbazol-3-yl]ethanone 1-(O-acetyloxime). The component (B) may contain one or more kinds thereof or a combination of two or more kinds thereof.

Preferably, the component (B) may contain an acylphosphine oxide-based compound. Preferred examples of the acylphosphine oxide-based compound include bis(2,4,6-trimethylbenzoyl)phenylphosphine oxide and 2,4,6-trimethylbenzoyldiphenylphosphine oxide. It is preferable that the photo radical polymerization initiator has excellent deep curing ability due to high sensitivity and photobleaching properties thereof, and also has an absorption wavelength region for generating radicals that extends into a relatively long wavelength region. In the preferred compound described above, the absorption wavelength region is in the range up to a wavelength of about 440 nm, and a difference from the absorption wavelength region of a UV absorber used in a UV laser peeling step to be described later is large. That is, the degree of UV curing inhibition by a UV absorber is small, and radical polymerization can be initiated by light having a longer wavelength. Therefore, it is possible to obtain an effect that radical polymerization can be efficiently initiated and cured at a relatively high speed even in the presence of a UV absorber.

In a preferred embodiment, the photo radical polymerization initiator can be selected based on absorbance. Specifically, a photo radical polymerization initiator can be selected from one or more kinds of compounds that satisfy any

one or more of conditions that an absorbance at a wavelength of 365 nm is 0.5 or more, an absorbance at a wavelength of 385 nm is 0.5 or more, and an absorbance at a wavelength of 405 nm is 0.5 or more, when dissolved at a concentration of 0.1 mass% in a solvent (for example, acetonitrile or toluene) having no maximum absorption in a wavelength region of 300 to 500 nm. Examples of the compound satisfying such conditions include 1-[9-ethyl-6-(2-methylbenzoyl)-9H-carbazole-3-yl]ethanone 1-(O-acetyloxime) having an absorbance at a wavelength of 365 nm which is 0.5 or more, 1-[4-(phenylthio) phenyl]-1,2-octanedione 2-O-benzoyloxime having an absorbance at wavelengths of 365 nm and 385 nm which is 0.5 or more, a bis(2,4,6-trimethylbenzoyl)phenylphosphine oxide and a 2,4,6-trimethylbenzoyldiphenylphosphine oxide having an absorbance at wavelengths of 365 nm, 385 nm, and 405 nm which is 0.5 or more, when dissolved at a concentration of 0.1 mass% in acetonitrile as a solvent.

In addition, from the viewpoint of achieving both curability and UV laser peelability by a photo radical polymerization initiator, bis($\eta^5$-2,4-cyclopentadiene-1-yl)-bis(2,6-difluoro-3-(1H-pyrrole-1-yl)-phenyl)titanium having an absorption wavelength region in the range of 400 to 500 nm can also be used as the photo radical polymerization initiator.

The photo radical polymerization initiator (B) is preferably one or more selected from an acylphosphine oxide-based compound, a titanocene-based compound, or an $\alpha$-aminoalkylphenone-based compound in that the photo radical polymerization initiator has a reaction rate, heat resistance after curing, low outgassing properties, and absorption characteristics in a region different from the wavelength of a UV laser used for UV laser peeling to be described later and the absorption wavelength region of a UV absorber used for the UV laser peeling. In addition, other than the above, an oxime ester-based compound can also be selected as a photo radical polymerization initiator for a resin composition used for temporary bonding to prevent a base material to be processed from being damaged from bonding to a support base material to a heating step, which is not a layer corresponding to a UV laser peeling process, in the composition for temporary bonding having a structure to be described later.

Examples of the acylphosphine oxide-based compound include bis(2,4,6-trimethylbenzoyl)phenylphosphine oxide and 2,4,6-trimethylbenzoyldiphenylphosphine oxide. Among them, the bis(2,4,6-trimethylbenzoyl) phenylphosphine oxide is particularly preferable.

Examples of the titanocene-based compound include bis($\eta^5$-2,4-cyclopentadiene-1-yl)-bis(2,6-difluoro-3-(1H-pyrrole-1-yl)-phenyl)titanium.

Examples of the $\alpha$-aminoalkylphenone-based compound include 2-benzyl-2-dimethylamino-1-(4-morpholinophenyl)-butane-1-one and 2-dimethylamino-2-(4-methylbenzyl)-1-(4-morpholine-4-ylphenyl)-butane-1-one.

Examples of the oxime ester-based compound include 1-[4-(phenylthio)phenyl]-1,2-octanedione 2-O-benzoyloxime and 1-[9-ethyl-6-(2-methylbenzoyl)-9H-carbazole-3-yl]ethanone 1-(O-acetyloxime). Among these, 1-[9-ethyl-6-(2-methylbenzoyl)-9H-carbazol-3-yl]ethanone 1-(O-acetyloxime) is preferred.

The used amount of the photo radical polymerization initiator (B) is preferably 0.01 to 5 parts by mass, and more preferably 0.1 to 1 part by mass, with respect to 100 parts by mass of the component (A), from the viewpoint of a reaction rate, heat resistance after curing, and low outgassing properties. When the component (B) is 0.01 parts by mass or more, sufficient curability is obtained, and when the component is 5 parts by mass or less, effects of low outgassing properties and heat resistance not being easily impaired are obtained.

The present composition may further contain a (meth)acrylate polymer as a component (C). Examples of such a (meth)acrylate polymer include a (meth)acrylic polymer or a (meth)acrylic copolymer having a (meth)acryloyl group in a side chain. Such a polymer is available, for example, as a product name "Art Resin" series manufactured by Negami Chemical Industrial Co., Ltd. or a product name "KANEKA XMAP" series manufactured by Kaneka Corporation. When the component (C) is added, an effect of easily adjusting the rigidity and flexibility of a crosslinked structure formed when the present composition is cured is obtained. It is more preferable that the component (C) does not contain a methacrylate polymer.

The weight average molecular weight of the component (C) is preferably 5000 to 200000. When the weight average molecular weight of the component (C) is 5000 or more, an appropriate viscosity is obtained when blended with another polymerizable component. When the weight average molecular weight of the component (C) is 10000 or more, an appropriate thickening effect is obtained. From this viewpoint, the weight average molecular weight of the component (C) is more preferably 6000 or more, and still more preferably 7000 or more. When the weight average molecular weight of the component (C) is 200000 or less, good spin coatability with low shear rate dependency is obtained. From this viewpoint, the weight average molecular weight of the component (C) is more preferably 190000 or less, still more preferably 180000 or less, still further preferably 150000 or less, and particularly preferably 100000 or less.

The functional group equivalent of the component (C) is preferably 500 to 20000, more preferably 700 to 10000, and most preferably 1000 to 7000.

In a case where the present composition contains the component (C), the amount of the component (A) may be 50 mass% or more and 95 mass% or less, preferably 50 mass% or more and 90 mass% or less, and more preferably 50 mass% or more and 85 mass% or less in a mass ratio of the component (A) and the component (C).

The present composition may further contain a UV absorber as a component (D). The UV absorber refers to, for example, a compound in which molecules are cleaved by irradiation with a laser of ultraviolet rays or visible light to be

decomposed and vaporized, and the decomposition and vaporization occur at an interface between a support base material (or a support) and a temporary bonding agent, thereby causing the loss of adhesion between the temporary bonding agent and the support base material (or the support) which has been maintained until immediately before the peeling step.

The UV absorber (D) is preferably one or more selected from benzotriazole-based compounds and hydroxyphenyltriazine-based compounds in terms of the degree of overlap with the UV laser wavelength in the UV absorption wavelength region, UV absorption characteristics at the same wavelength, low outgassing properties, and heat resistance.

Preferably, the UV absorber may have one or a plurality of polymerizable functional groups (such as a (meth)acryloyl group, a vinyl ether group, and an ester group). In a case where the UV absorber has a (meth)acryloyl group, the UV absorber is regarded as not corresponding to the component (A). When the component (D) having such a polymerizable functional group is used, there is an effect that a more appropriate crosslinked structure is obtained.

The benzotriazole-based compound is particularly preferably one or more selected from the group consisting of 2-[2-hydroxy-5-[2-((meth)acryloyloxy)ethyl]phenyl]-2H-benzotriazole, 2,2'-dihydroxy-4,4'-di-2-(meth)acryloyloxyethoxybenzophenone, 2-(2H-benzotriazole-2-yl)-4,6-bis(1-methyl-1-phenylethyl)phenol, 2,2'-methylene bis[6-(2H-benzotriazole-2-yl)-4-(1,1,3,3-tetramethylbutyl)phenol], 2-(2H-benzotriazole-2-yl)-6-(1-methyl-1-phenylethyl)-4-(1,1,3,3-tetramethylbutyl)phenol, and 2-[2-hydroxy-3-(3,4,5,6-tetrahydrophthalimide-methyl)-5-methylphenyl]benzotriazole, in terms of compatibility with a resin component, UV absorption characteristics, low outgassing properties, and heat resistance.

The hydroxyphenyltriazine-based compound is particularly preferably one or more selected from the group consisting of 2-[4-[(2-hydroxy-3-(2'-ethyl)hexyl)oxy]-2-hydroxyphenyl]-4,6-bis(2,4-dimethylphenyl)-1,3,5-triazine, 2,4-bis(2-hydroxy-4-butyloxyphenyl)-6-(2,4-bis-butyloxyphenyl)-1,3,5-triazine, and 2,4,6-tris(2-hydroxy-4-hexyloxy-3-methylphenyl)-1,3,5-triazine, in terms of compatibility with the component (A), UV absorption characteristics, low outgassing properties, and heat resistance.

The UV transmittance of a cured product in the present specification is a value obtained by reflectance measurement spectroscopy. Specifically, the transmittance can be obtained using a reflectance spectrophotometer (V-650 manufactured by JASCO Corporation) using a film of a cured product having a thickness of about 50 μm produced by sandwiching the film between PET resin sheets under the following conditions.

Cell length: 10 mm
Photometry mode: T (Transmittance)
Measurement range: 450 to 200 nm
Data acquisition interval: 1 nm
UV/vis bandwidth: 2.0 nm
Response: medium
Scanning speed: 40 nm/min
Light source switching: 340 nm
Light source: D2/WI
Filter switching: Step
Correction: Baseline

The amount of the UV absorber as the component (D) is preferably 0.001 to 15 parts by mass, preferably 0.005 to 10 parts by mass, preferably 0.01 to 5 parts by mass, and more preferably 0.5 to 2.5 parts by mass, based on 100 parts by mass of a total of the component (A) and, if present, the component (C). When the amount of the component (D) is 0.001 parts by mass or more, sufficient UV laser peeling rate is obtained, and when the amount is 15 parts by mass or less, effects of low outgassing properties and heat resistance not being easily impaired are obtained.

The weight average molecular weight in the present specification is a value in terms of standard polystyrene measured by a gel permeation chromatography (GPC) method. Specifically, the weight average molecular weight is determined by preparing a calibration curve with commercially available standard polystyrene using tetrahydrofuran as a solvent by using a GPC system (SC-8010 manufactured by Tosoh Corporation) under the following conditions.

Flow rate: 1.0 ml/min
Set temperature: 40°C
Column: 1 column of "TSK guardcolumn MP (×L)" 6.0 mmID × 4.0 cm manufactured by Tosoh Corporation and 2 columns of "TSK-GELMULTIPOREHXL-M" 7.8 mmID × 30.0 cm (theoretical plate number of 16,000) manufactured by Tosoh Corporation, for a total of 3 columns (theoretical plate number of 32,000 stages as a whole)
Sample injection amount: 100 μl (sample liquid concentration of 1 mg/ml)
Liquid feeding pressure: 39 $kg/cm^2$
Detector: RI detector (differential refractive index detector)

The present composition can be used as a temporary bonding resin composition, a temporary bonding adhesive, a pressure-sensitive adhesive sheet, or a temporary bonding adhesive for manufacturing an electronic device. In the present specification, the composition for temporary bonding, the temporary bonding resin composition, and the temporary bonding adhesive may be collectively referred to as a temporary bonding agent.

When the optically transparent support base material (or a support) is bonded to a base material to be processed using the present composition, irradiation with visible light or ultraviolet rays (wavelength or central wavelength of 365 to 405 nm) is preferably performed so that the energy amount is 1 to 20000 mJ/$cm^2$. When the energy amount is 1 mJ/$cm^2$ or more, sufficient adhesion is obtained, and when the energy amount is 20000 mJ/$cm^2$ or less, productivity is excellent, a decomposition product from the photo radical polymerization initiator is less likely to be generated, and generation of outgas is suppressed. It is preferably 1000 to 10000 mJ/$cm^2$ in terms of productivity, adhesion, low outgassing properties, and easy peelability.

The base material to be bonded by the present composition is not particularly limited, but at least one base material is preferably a transparent base material that transmits light. Examples of the transparent base material include inorganic base materials such as crystal, glass, quartz, calcium fluoride, and magnesium fluoride, and organic base materials such as plastic. Among them, the inorganic base materials are preferable in terms of having versatility and obtaining a large effect. Among the inorganic base materials, one or more selected from glass and quartz are preferable.

The present composition may be a photocurable type, and a cured product provided thereby has excellent heat resistance and peelability. In one embodiment, a cured product of the composition of the present invention has a small amount of outgassing even when exposed at a high temperature, and is suitable for bonding, sealing, and coating various optical components, optical devices, and electronic components. The composition of the present invention is suitable for applications requiring a wide range of durability such as solvent resistance, heat resistance, and adhesion, particularly for semiconductor manufacturing process applications.

The cured product of the present composition can be used for a process in a wide temperature range from room temperature to high temperature. The heating temperature during the process is preferably 350°C or lower, more preferably 300°C or lower, and most preferably 250°C or lower. In a preferred embodiment, the temperature at which a heat mass reduction rate of the cured product is 2% may be 250°C or higher. An adhered body bonded by the present composition has high shear adhesive strength, and therefore can withstand a thinning step and the like, and can be easily peeled off after passing through a heating step such as formation of an insulating film. When used at a high temperature, the cured product of the present composition can be used, for example, in a process at a high temperature of preferably 200°C or higher, and more preferably 250°C or higher.

In an embodiment, an adhered body in which a base material is bonded by using the present composition as an adhesive is also provided. The adhered body can be peeled off by applying an external force. For example, it can be peeled off by inserting a blade, a sheet, or a wire into a bonded portion. Alternatively, it is also possible to peel off the adhered body by irradiating an entire surface with a UV laser or an IR laser so as to scan from the optically transparent base material side of the adhered body.

In an embodiment, a method for manufacturing a semiconductor device may also be provided. In the method, the following steps may be performed. First, the above-described composition is applied (spin coating or the like) to a semiconductor wafer substrate and/or a support member. Then, the semiconductor wafer substrate and the support member are bonded in a vacuum environment with the composition interposed therebetween. The semiconductor wafer substrate and the support member bonded to each other are irradiated with light (for example, ultraviolet light) to cure the composition, thereby temporarily bonding the semiconductor wafer substrate and the support member to each other. The temporarily bonded portion can be peeled off by the above-described method.

Any thickness of the present composition when applied to a semiconductor wafer substrate or a support member can be set according to applications, and for example, it is preferably in the range of 50 μm or more and 70 μm or less.

The vacuum environment used for bonding can be set to any vacuum degree, and can be set to, for example, 20 Pa or less.

## Examples

Hereinafter, the present invention will be described in more detail based on Examples and Comparative Examples, but the present invention is not limited thereto.

The experiment was performed at a temperature of 23°C and a humidity of 50% unless otherwise specified. Composition for temporary bonding having the composition (unit: part(s) by mass) shown in the following table were prepared and evaluated. As each component, the following compounds were selected.

[Table 1]

| Name of raw materials | Kind of raw materials | | Specific gravity of raw materi-als | Exam-ple 1 | Exam-ple 2 | Exam-ple 3 | Exam-ple 4 | Exam-ple 5 | Exam-ple 6 | Compara-tive Example 1 | Compara-tive Example 2 | Compara-tive Example 3 | Compara-tive Example 4 | Compara-tive Example 5 | Compara-tive Example 6 | Compara-tive Example 7 |
|---|---|---|---|---|---|---|---|---|---|---|---|---|---|---|---|---|
| A-BPEF-2 | Component (A-1) | Bifunctional | 1.195 | 10 | 10 | 10 | 10 | 10 | 10 | 30 | 30 | 10 | 10 | - | - | - |
| A-BPE-2 | Component | Bifunctional | 1.135 | - | | 22.5 | - | 15 | 15 | 2.5 | 2.5 | 22.5 | 22.5 | - | - | - |
| ABE-300 | Component (A-1) | Bifunctional | 1.142 | - | - | - | 5 | - | - | - | - | - | - | - | 100 | - |
| HBPE-4 | Component (A-1) | Bifunctional | 1.071 | 25 | 25 | - | 25 | - | - | - | - | - | 10 | - | - | - |
| HX-620 | Component | Bifunctional | 1.072 | - | - | 7.5 | | 7.5 | | 67.5 | 67.5 | 7.5 | 7.5 | 100 | - | - |
| HX-220 | Component (A-1) | Bifunctional | 1.065 | - | - | - | - | - | 7.5 | - | - | - | - | - | - | - |
| A-DOD-N | Component (A-1) | Bifunctional | 0.973 | 10 | 10 | - | 10 | - | - | - | - | - | - | - | - | - |
| A-TMPT | Component (A-1) | Trifunctional | 1.106 | - | - | - | - | 7.5 | 7.5 | - | - | - | - | - | - | - |
| M-113 | Compo-nent (A-2) | Monofunction-al | 1.025 | 10 | 10 | - | 5 | 12.5 | 10 | - | - | 10 | 10 | - | - | 100 |
| ISTA | Compo-nent (A-2) | Monofunction-al onal | 0.866 | 30 | 30 | 30 | 30 | 20 | 20 | - | - | 20 | 20 | - | - | - |
| 1819 | Component (B) | | | 0.5 | 0.5 | 0.5 | 1 | 1 | 1 | 0.5 | 0.5 | 1 | 1 | 0.5 | 0.5 | 0.5 |
| APB-001 | Component (C) | | 1.075 | 15 | 15 | - | 15 | - | - | - | - | - | - | - | - | - |
| RC110C | Component (C) | | 1.043 | - | - | 30 | | 27.5 | 30 | - | - | - | - | - | - | - |
| RUVA-93 | Component (D) | | | 3 | 5 | 5 | 5 | 5 | 5 | 3 | 5 | 5 | 5 | 5 | 5 | 5 |

(continued)

| Name of raw materials | Kind of raw materials | | Specific gravity of raw materials | Example 1 | Example 2 | Example 3 | Example 4 | Example 5 | Example 6 | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|---|---|---|---|---|---|---|
| P-66 | Component | | | - | 4 | 4 | 4 | 4 | 4 | - | 4 | 4 | 4 | 4 | 4 | 4 |
| | (D) | | | | | | | | | | | | | | | |
| Specific gravity [g/cm$^3$] | | | | 1.016 | 1.017 | 1.026 | 1.022 | 1.048 | 1.050 | 1.117 | 1.117 | 1.052 | 1.060 | 1.072 | 1.142 | 1.025 |
| Evaluation of bubbles | | | | Absence | Absence | Absence | Absence | Absence | Absence | Presence | Presence | Presence | Presence | Absence | Presence | Absence |
| Viscosity [mPa·s] | | | | 1261 | 1329 | 1962 | 1567 | 1638 | 1818 | 1852 | 2114 | 2299 | 1698 | 350 | 2315 | 110 |
| Evaluation of backflow | | | | Absence | Absence | Absence | Absence | Absence | Absence | Absence | Absence | Absence | Absence | Presence | Absence | Presence |

The unit of the used amount is part(s) by mass.

[Composition]

As the component (A-1), the following materials were used.

A-BPEF-2: 9,9-bis[4-(2-hydroxyethoxy)phenyl]fluorene diacrylate ("NK Ester A-BPEF-2" manufactured by Shin Nakamura Chemical Co., Ltd.)
A-BPE-2: Ethoxylated bisphenol A diacrylate ("NK Ester A-BPE-2" manufactured by Shin Nakamura Chemical Co., Ltd., R = $-CH_2CH_2O-$, m = n = 1 in the following structural formula)
ABE-300: Ethoxylated bisphenol A diacrylate ("NK Ester ABE-300" manufactured by Shin Nakamura Chemical Co., Ltd., R = $-CH_2CH_2O-$, m + n ≈ 3 in the following structural formula)

[Chem. 2]

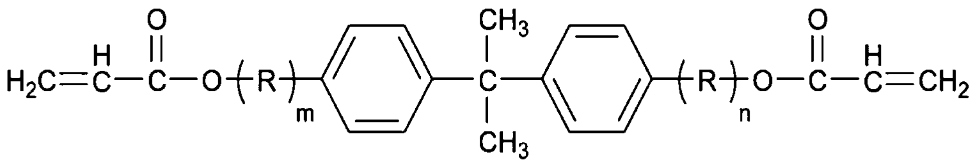

HBPE-4: EO-modified hydrogenated bisphenol A diacrylate ("HBPE-4" manufactured by DKS Co. Ltd., m + n ≈ 4)
HX-620: Caprolactone-modified hydroxypivalic acid neopentyl glycol diacrylate ("KAYARAD HX-620" manufactured by Nippon Kayaku Co., Ltd., m + n ≈ 4)
HX-220: Caprolactone-modified hydroxypivalic acid neopentyl glycol diacrylate ("KAYARAD HX-220" manufactured by Nippon Kayaku Co., Ltd., m + n ≈ 2)
A-DOD-N: 1,10 Decanediol diacrylate ("NK Ester A-DOD-N" manufactured by Shin Nakamura Chemical Co., Ltd.)
A-TMPT: Trimethylolpropane triacrylate ("NK Ester A-TMPT" manufactured by Shin Nakamura Chemical Co., Ltd.)

As the component (A-2), the following materials were used.

M-113: Nonylphenol EO-modified acrylate ("ARONIX M-113" manufactured by Toagosei Co., Ltd., n ≈ 4)
ISTA: Isostearyl acrylate ("ISTA" manufactured by Osaka Organic Chemical Industry Ltd.)

As the component (B), the following materials were used.
I819: Bis(2,4,6-trimethylbenzoyl)phenylphosphine oxide ("Irgacure 819" manufactured by BASF)
As the component (C), the following materials were used.

APB-001: Polybutyl acrylate polymer containing an acryloyl group in a side chain ("APB-001" manufactured by Negami Chemical Industrial Co., Ltd., weight average molecular weight of 72,000, functional group equivalent of 1400)
RC110C: Polybutyl acrylate polymer having acryloyl groups at both terminals ("KANEKA XMAP RC110C" manufactured by Kaneka Corporation, weight average molecular weight of 12,000, functional group equivalent of 6,000, having the following structural formula)

[Chem. 3]

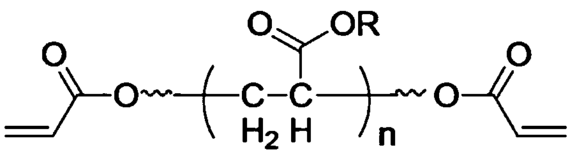

As the component (D), the following materials were used.

RUVA-93: 2-[2-Hydroxy-5-[2-(methacryloyloxy)ethyl]phenyl]-2H-benzotriazole ("RUVA-93" manufactured by Otsuka Chemical Co., Ltd.)

P-66: 2,2'-Dihydroxy-4,4'-di-2 acryloyloxyethoxybenzophenone ("DAINSORB P-66" manufactured by Daiwa Fine Chemicals Co., Ltd.)

[Preparation of Liquid Sample, Measurement of Viscosity, and Measurement of Specific Gravity]

Each component described in Table 1 was warmed and mixed at 70°C to obtain a composition for temporary bonding. For each of the obtained composition for temporary bonding, the viscosity was measured in accordance with JIS Z 8803:2011 under the following conditions.

Measuring apparatus: E-type viscometer DV3T-HB (manufactured by EKO Instruments Co., Ltd.)
Measurement jig: Cone plate CPA-40Z (manufactured by EKO Instruments Co., Ltd.)
Measurement temperature: 23°C
Rotation speed: 10 rpm
Shear rate: 1 $sec^{-1}$

In addition, for each of the composition for temporary bonding, the specific gravity was measured in accordance with JIS Z 8804:2012 under the following conditions based on the above-described calculation formula.

Apparatus: 5 mL Pycnometer
Measurement temperature: 23°C
Solvent: Pure water

[Spin Coating Application]

The composition for temporary bonding obtained above was applied onto a silicon wafer by spin coating at room temperature (23°C), a glass substrate and the wafer were bonded together in a vacuum bonding apparatus at 20 Pa or less, the pressure was returned to normal pressure, and then the composition for temporary bonding was cured by irradiating the glass base material side with light having a wavelength of 405 nm at an irradiation intensity of 350 $mW/cm^2$ and an irradiation time of 16 sec to obtain a laminate. This laminate had a configuration having layers of glass substrate/composition for temporary bonding/silicon wafer in this order, the thickness of the composition for temporary bonding was 70 $\mu$m, and the adhesion area was 177 $cm^2$.

[Evaluation of Presence or Absence of Bubble Retention]

As described above, the laminate obtained by curing the composition applied by spin coating was observed at a magnification of 5 times using a stereoscopic microscope ("SZX7" manufactured by OLYMPUS), and the presence or absence of bubbles inside was confirmed. The results of the presence or absence are shown in the table.

[Evaluation on Presence or Absence of Backflow]

The end of a silicon wafer surface of the laminate obtained by curing by the spin coating was observed using a stereoscopic microscope ("SZX7" manufactured by OLYMPUS), and the case where there was liquid leakage of 0.1 $mm^2$ or more was determined as "presence", and the case where there was no liquid leakage was determined as "absence".

From the above results, it could be confirmed that in any of the compositions according to Examples of the present invention, no bubbles remained and no backflow occurred.

On the other hand, in all of Comparative Examples 1 to 4 and 6 in which the specific gravity condition was not satisfied, bubbles remained.

In Comparative Example 5 in which the conditions for both the specific gravity and the viscosity were not satisfied, no bubble retention was observed, but the backflow occurred.

Even in Comparative Example 7 in which the viscosity condition was not satisfied, the backflow occurred.

## Claims

**1.** A composition for temporary bonding which is photocurable, comprising:

(A) a (meth)acrylate monomer; and
(B) a photo radical polymerization initiator,

wherein a viscosity of the composition for temporary bonding at 23°C determined in accordance with JIS Z 8803:2011 is 500 mPa·s or more at a shear rate of 1 $sec^{-1}$, and
a specific gravity of the composition for temporary bonding at 23°C determined in accordance with JIS Z 8804:2012 is 1.000 $g/cm^3$ or more and 1.050 $g/cm^3$ or less.

**2.** The composition for temporary bonding according to claim 1,

wherein the component (A) comprises
(A-1) a polyfunctional (meth)acrylate monomer, and
(A-2) a monofunctional (meth)acrylate monomer.

**3.** The composition for temporary bonding according to claim 2, wherein a mass ratio of the component (A-1) to the component (A-2) is in a range of (A-1):(A-2) = 2:1 to 1:2.

**4.** The composition for temporary bonding according to claim 2, wherein the component (A-2) comprises an aliphatic monofunctional (meth)acrylate monomer having 15 or more and 32 or less carbon atoms.

**5.** The composition for temporary bonding according to claim 1, further comprising:
(C) a (meth)acrylate polymer.

**6.** The composition for temporary bonding according to any one of claims 1 to 5, which does not comprise a methacrylate monomer and a methacrylate polymer.

**7.** The composition for temporary bonding according to any one of claims 1 to 5, further comprising:
(D) a UV absorber.

**8.** The composition for temporary bonding according to any one of claims 1 to 5, which does not comprise a filler.

**9.** A method for manufacturing a semiconductor device, the method comprising the steps of:

applying a composition to a semiconductor wafer substrate and/or a support member;
bonding the semiconductor wafer substrate and the support member in a vacuum environment with the composition interposed therebetween; and
temporarily bonding the semiconductor wafer substrate and the support member to each other by irradiating the semiconductor wafer substrate and the support member bonded to each other with light and curing the composition,
wherein the composition before curing comprises:

(A) a (meth)acrylate monomer; and
(B) a photo radical polymerization initiator,

a viscosity of the composition at 23°C determined in accordance with JIS Z 8803:2011 is 500 mPa·s or more at a shear rate of 1 $sec^{-1}$, and
a specific gravity of the composition at 23°C determined in accordance with JIS Z 8804:2012 is 1.000 $g/cm^3$ or more and 1.050 $g/cm^3$ or less.

**10.** The method according to claim 9, wherein the composition is applied to the semiconductor wafer substrate and/or the support member by spin coating.

**11.** The method according to claim 9 or 10, wherein an application thickness of the composition on the semiconductor wafer substrate and/or the support member is in a range of 50 μm or more and 70 μm or less.

**12.** The method according to claim 9 or 10, wherein the vacuum environment is within a range of a vacuum degree of 20 Pa or less.

**13.** A composition comprising:

(A) a (meth)acrylate monomer; and

(B) a polymerization initiator,
wherein a viscosity of the composition at 23°C determined in accordance with JIS Z 8803:2011 is 500 mPa·s or more at a shear rate of 1 $sec^{-1}$, and
a specific gravity of the composition at 23°C determined in accordance with JIS Z 8804:2012 is 1.000 $g/cm^3$ or more and 1.050 $g/cm^3$ or less.

**INTERNATIONAL SEARCH REPORT**

International application No. **PCT/JP2024/001600**

**A. CLASSIFICATION OF SUBJECT MATTER**

***C09J 4/02***(2006.01)i; ***C08F 20/10***(2006.01)i; ***C08F 220/20***(2006.01)i; ***C08F 290/12***(2006.01)i; ***C09J 11/06***(2006.01)i; ***C09J 133/00***(2006.01)i; ***H01L 21/02***(2006.01)i
FI: C09J4/02; C08F20/10; C08F220/20; C08F290/12; C09J11/06; C09J133/00; H01L21/02 C

According to International Patent Classification (IPC) or to both national classification and IPC

**B. FIELDS SEARCHED**

Minimum documentation searched (classification system followed by classification symbols)

C09J4/02; C08F20/10; C08F220/20; C08F290/12; C09J11/06; C09J133/00; H01L21/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-181263 A (KANEKA CORP.) 29 September 2014 (2014-09-29) claims, paragraphs [0008], [0038]-[0040], [0068]-[0086], [0098]-[0101], [0105], [0106], [0129], [0132], examples | 1-8, 13 |
| Y | WO 2022/230874 A1 (DENKA CO., LTD.) 03 November 2022 (2022-11-03) claims, paragraphs [0012], [0055], [0056], [0063]-[0069], [0072], [0082], [0083], [0098], [0104]-[0110], [0118], examples | 1-13 |
| Y | WO 2020/101000 A1 (DENKA CO., LTD.) 22 May 2020 (2020-05-22) claims, paragraphs [0012], [0037]-[0072], examples | 1-13 |
| A | JP 2021-021032 A (SHOWA DENKO K.K.) 18 February 2021 (2021-02-18) entire text | 1-13 |
| A | JP 2013-539489 A (HENKEL CORPORATION) 24 October 2013 (2013-10-24) entire text | 1-13 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 March 2024** | **09 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/001600**

| Patent document cited in search report | Publication date (day/month/year) | Patent family member(s) | Publication date (day/month/year) |
|---|---|---|---|
| JP 2014-181263 A | 29 September 2014 | (Family: none) | |
| WO 2022/230874 A1 | 03 November 2022 | CN 117242146 A<br>claims, examples<br>KR 10-2023-0156137 A | |
| WO 2020/101000 A1 | 22 May 2020 | US 2022/0010116 A1<br>claims, paragraphs [0018], [0054]-[0095], examples<br>EP 3882323 A1<br>CN 113056533 A<br>KR 10-2021-0091172 A | |
| JP 2021-021032 A | 18 February 2021 | (Family: none) | |
| JP 2013-539489 A | 24 October 2013 | US 2014/0011904 A1<br>entire text<br>WO 2012/024070 A2<br>EP 2606098 A2<br>CN 103068945 A<br>KR 10-2013-0097724 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2021235406 A
- JP 2005159155 A